# EUROPEAN PATENT SPECIFICATION

(11) **EP 0 292 515 B1**
(45) Date of publication and mention of the grant of the patent: **23.06.1993**
(21) Application number: 87907436.7
(22) Date of filing: 18.11.1987
(51) Int. Cl.: G01R 35/00

(54) **A HIGH SPEED SAMPLING APPARATUS AND METHOD FOR CALIBRATING THE SAME**
Schnelle Abtast-Halteschaltung und Verfahren zu deren Kalibrierung
APPAREIL D'ECHANTILLONNAGE A HAUTE VITESSE ET PROCEDE DE CALIBRAGE DUDIT APPAREIL

(30) Priority: 18.11.1986 GB 8627533
(43) Date of publication of application: 30.11.1988
(73) Proprietor: GOULD ELECTRONICS LIMITED, Sutton Surrey, SN1 1BY (GB)
(72) Inventor: MILLER, Allen, Gwynedd LL30 3RN (GB)
(74) Representative: Crawford, Andrew Birkby
(86) International application number: GB8700817
(87) International publication number: WO8804059

(56) References cited:
- International Test Conference, 1986, Proceedings, Testing's Impact on Design and Technmology, 8-11 September 1986, IEEE, (Philadelphia, US), W. Dammet al.: "Venier Method for calibration of high-speed sampling system", page 220

## Description

The present invention relates to the calibration of components used in a high speed sampling apparatus such as a digital storage oscilloscope.

Digital storage oscilloscopes capable of capturing rapid transients in analogue waveforms conventionally make use of a high speed analogue to digital (ADC) converter system. This is followed by a digital store operating at the clock rate of the ADC. The captured waveform can then be displayed at a much slower speed when the digitised data is read out from the digital store. Mass production of Ultra-high speed semiconductor ADC's can be technology-limited particularly when required to perform at a high accuracy (e.g. 8 Bit or better at digitising rates greater than 200 MHZ). These devices are therefore difficult to produce and hence expensive. This also applies to some extent to the digital store. An alternative approach is to use a Charge Coupled Device (CCD) for the conversion process. This component operates as a temporary analogue store, capturing the waveform in much the same way as would be done conceptually by a number of sample and hold circuits. The captured analogue waveform can then be read out from the CCD much more slowly into a low cost ADC and store system. The CCD therefor has a useful property in that it can accurately capture the value of an analogue waveform. Intrinsically, the CCD is not capable of being clocked at particularly high speeds mainly due to limitations in the MOS process. However, high clocking rates can be achieved by time-multiplexing a number of CCD lines. Matching between these lines can be kept to reasonable tolerances provided that they are integrated on a common semiconductor substrate The difficulty which arises is that this matching is by no means perfect.

It is the object of this invention to describe a means by which the timing accuracy of each of the multiplexed lines can be accurately measured and corrected by using a software technique.

An earlier proposal which achieves this object was disclosed in a paper in International Test Conference 1986 Proceedings, Testings Impact on Design and Technology, September 8 to 11 1986, entitled "Vernier Method for Calibration of High Speed Sampling System" by W. Damm et al. In this disclosure a system is described for calibrating a logic analyser using a reference signal whose frequency is slighly greater than one tenth of the sampling frequency of the device. In the example given the reference signal frequency is 50.064MHz and the sample frequency is 500MHz. When the analyser samples the reference signal the sampled points "process through" the reference waveform. When the analyser is correctly calibrated the sampling of the reference signal will produce a predetermined "pattern". A mathematical algorithm is used to adjust the timing of the clock signals to the individual sampling devices until this predetermined "pattern" is achieved.

This proposed system has several disadvantages. For example, it is only applicable to logic (2 level) waveforms, and it is limited in terms of its resolution of adjustment. Furthermore, problems may be encountered due to the relative jitter between the two clock oscillators for the clock signal and the reference signal respectively. Also, calibration takes a considerable amount of time because the complete "pattern" contains a large number of samples (768 in the described example).

The present invention provides a method of calibrating a high speed sampling apparatus including a plurality of time multiplexed sampling devices controlled by respective clock signals the method comprising applying a reference signal to the apparatus to produce a sampled output and adjusting the timing of one or more of the clock, signals in a manner depending on the sampled output, characterised in that the reference signal is a periodic signal derived from the same source as the respective clock signals and the timing of the clock signal(s) is adjusted to produce a straight line sampled output.

It is also of interest to note that this correction technique may also be applied to multiplexing slower speed ADC's in a similar way to achieve a similar result.

The present invention also provides a sampling apparatus comprising a clock signal generator, a plurality of sampling devices driven by a respective clock signal from said generator whereby to time multiplex said devices, variable delay means for selectively delaying the respective clock signals from the generator, means for supplying a reference signal to said devices to produce a sampled output, and means for adjusting at least one of the variable delay means in response to the sampled output;
characterised in that the reference signal is a periodic signal derived from the clock signal generator and in that said adjusting means is arranged to adjust the timing of the clock signals to produce a straight line sampled output.

Preferably, a microprocessor is used to control the variable delay means during the calibration procedure.

In order that the present invention be more clearly understood, an embodiment thereof will now be described by way of example with reference to the accompanying drawings, in which:-
Fig. 1 shows a block diagram of a circuit according to an embodiment of the present invention,
Fig. 2 shows timing waveforms for clocks used in Fig. 1; and
Figs. 3(a) and 3(b) show waveforms useful for explaining the operation of the circuit shown in Fig. 1.

Before discussing the preferred embodiment of the present invention, it is considered helpful if the problems of the prior arrangements were described.

As an example, the CCD consists of an 8 section device with each section clocked at frequencies up to 50 MHz in a multiplexed mode so that the upper effective clocking rate is 400 MHz (i.e. 8 x 50 MHz). Multiplexing CCD's is a method well known in the art for achieving higher clock rates than could otherwise be achieved by simply clocking a single line at a faster rate. The problem with multiplexing, however, is that there is an inherent matching accuracy between each of the multiplexed lines giving rise to errors which fall into the following categories:-
1) DC offset mismatch
2) Gain mismatch
3) High speed sampling matching.

In the case of the first two error sources, the cause generally reduces to small mismatches within the capacitive elements which constitute the line. These can generally be compensated for by either analogue or digital means when the signals are read out at a speed slower than the sampling frequency from the CCD device. The high speed sampling error mismatch however need not necessarily be solely a function of the CCD but could also relate to any errors between the timing of the clocking system for the 8 phases. This error only manifests itself when a high analogue input frequency is fed into the CCD. For example, to capture a 100 MHz analogue input waveform to 8 bit accuracy, a maximum sampling uncertainty of 6pS must be achieved. This presents difficulties when a CCD is being set up manually due to problems such as:-
a) drift
b) finding a true point of reference
c) time spent in setup and testing.

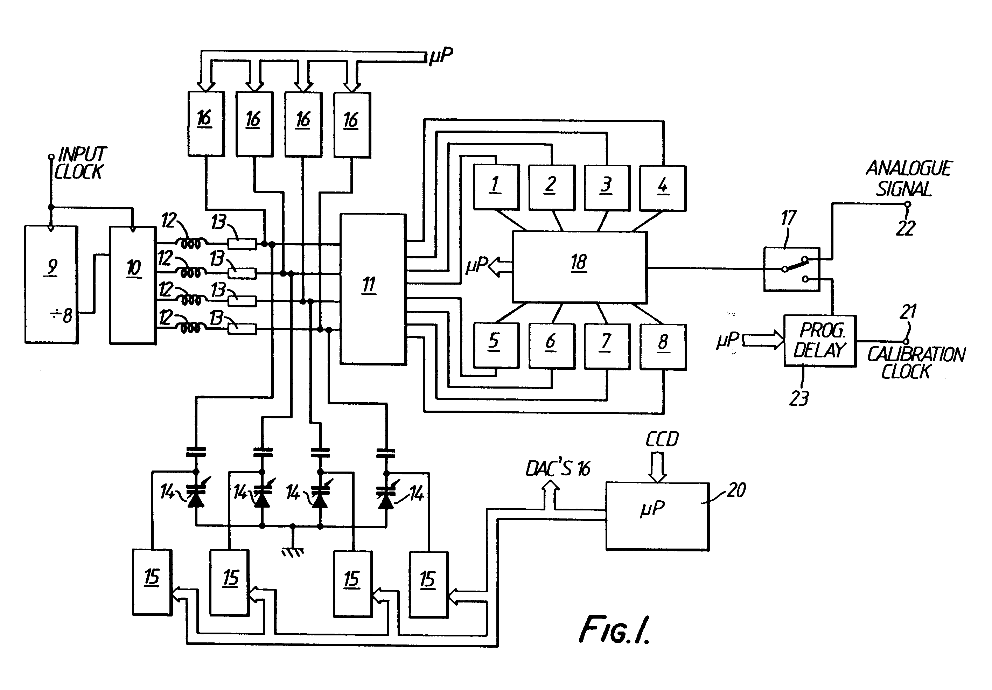

Turning now to the present invention, Fig. 1 shows the block diagram of a CCD data capture system. This consists of 8 clock drives (1 to 8) which supply sampling clocks to a CCD (18) as described above. These clocks are controlled by a counter (9), shift register (10) having a plurality, in this case four outputs and logic driver (11) which supplies 4 paraphase clocks to the clock drivers.

Connected in series with each output of the shift register (10) is a variable delay element which consists of a coil, (12) resistor (13) and varactor diode (14). (A plurality of these elements exists according to the number of multiplexed lines within the CCD). Each of these variable delay elements is under control of a microprocessor (20) using a respective digital to analogue converter (DAC) 15. This allows incremental adjustment to be made of the group delay on each paraphase pair of clock signals.

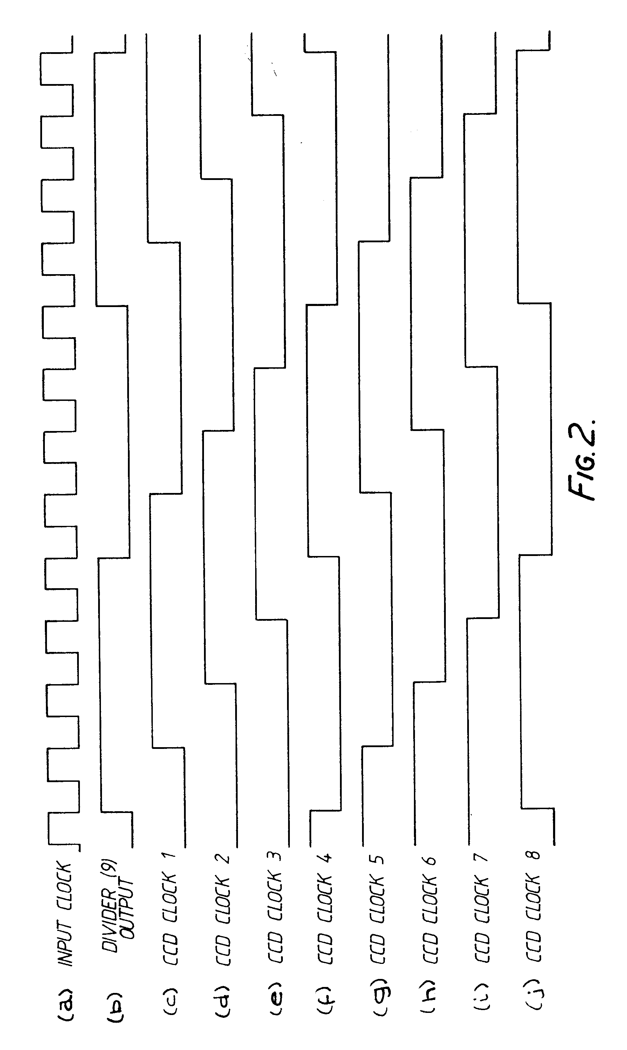

Fig. 2 shows the waveforms of the paraphase clocks to the clock drivers (1 to 8). Waveform (a) shows the input clock signal which is divided by the circuit (9) to provide a pulse output as shown in waveform (b). The pulse output from the divider circuit (9) is successively delayed by each of the delay elements to derive the waveforms c-f which are fed to the clock drivers 1-4 of the CCD (18). The delay elements also produce the paraphase waveforms g-j which are fed to the clock drivers 5-8 of the CCD, the waveform g being the inverse of waveform c etc.

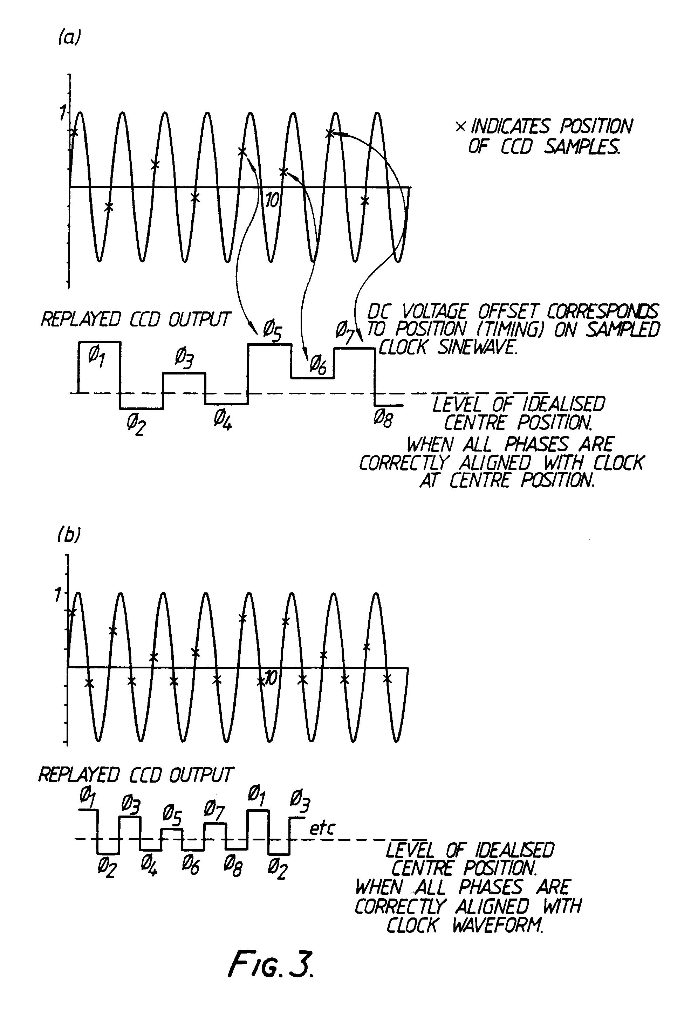

Secondly, it is necessary to incrementally adjust the mark to space ratio of the signals within the paraphase pair. Normally, because of the high clocking speeds involved here, emitter coupled logic (ECL) is used and the mark to space ratio can be conveniently adjusted by modifying the threshold potential applied to the logic. This is controlled by further DAC's (16), using the resistors (13) as the current to voltage control elements. Hence, by using a combination of the controls on the variable delay elements and the mark-space elements; the absolute timing on any individual CCD line can be controlled. This uniquely dictates the point at which each multiplexed element of the CCD line takes its sample. Hence by controlling the values of the signals sent to the DAC's (15) and (16) the position of the sampling edge can be accurately controlled. Uncalibrated sampling of a waveform is shown in Fig. 3a.

The DAC's (15) and (16) are controlled by a microprocessor (20) which processes sampled output data from the CCD (18) to produce correction signals for application to the DAC's (15) and/or (16) in a feedback loop control strategy which will now be described.

The feedback loop control strategy makes use of the input clock fed to the input counter (9) and shift register (10). It is assumed that the input clock to the system is pure and hence this is used as the reference signals. A portion of the clock signal is tapped off and fed via an input terminal (21) to the CCD analogue input during the calibration phase by switch (17). The CCD (18) then samples its own clock, and having previously removed the DC offset and gain errors as described in 1 and 2, the phase delay elements and mark-space control elements are adjusted for a straight line trace under the control of the microprocessor. When the clock signal is sampled by the CCD the slow speed replayed output will give a DC voltage proportional to the sampled signal level taken at the edge of its own clock. Ideally if all samples of the multiplexed line within the CCD are taken at the same signal level on the clock waveform then the replayed output from the CCD will be a straight line as indicated by the dotted line in Fig. 3a. Any difference in timing will show as an error voltage from this straight line and derived by the microprocessor which will control a suitable delay or mark-space ratio element to remove this error. Having used this clock signal as a sampling point calibration means, the clock signal is then removed from the CCD analogue input and replaced by the main, signal path from input terminal (22) using the changeover switch (17). The DAC's (15) and (16) then retain the calibration values for delay and mark space ratio and the positional sampling accuracy is maintained.

It is possible to introduce a programmable delay device (23) between the input terminal (21) and the changeover switch (17), the delay device also being controlled by an output from the processor (20) whereby to facilitate calibration.

A variation of this method exists when the calibration clock runs at only half the value of the effective CCD clocking rate. Such is the case when the logic is speed limited and the multiplexed clocking to the CCD is provided by using delay line techniques. In this case the calibration clock must have an even mark to space ratio. This is conveniently done by filtering the clock into a sinusoid. In this case, the CCD is made to sample both edges of the clock signal, and the variable delay/mark space elements are adjusted so that the sinewave clock is sampled at its mid point. (See Fig. 3b.)

It will be appreciated that the use of 8 clock drivers is for explanatory purposes only and the number of multiplexed lines and hence the number of clock drivers may be altered depending on the speed required of the circuitry.
The features of the above circuit are:
1) A calibration method for a multiplexed CCD or sample and hold circuits to set up the timing of the sampling clocks by using the system clock as a time reference.
2) A calibration method for a multiplexed CCD or sample and hold circuits to set up the timing position of the sampling clocks by using an analogue or digitally generated ramp as a reference.
3) a method of using a multiplexed CCD or sample and hold circuits to sample its clock signal as described in (2) above but where both edges of the clock signal are sampled.
4) A method using a combination of variable delay elements and/or mark-space ratio using digital or analogue control to accurately set the timing position of the sample clocks in a CCD.

When the above features are applied to correct a number of multiplexed Analogue to Digital converters, a high speed composite converter may be produced with accurately controlled timing.

When the above features are applied to correct a number of multiplexed Sample-and-Hold circuits, a composite higher speed Sample-and-Hold system may be produced with accurate timing.

## Claims

1. A method of calibrating a high speed sampling apparatus including a plurality of time multiplexed sampling devices (18) controlled by respective clock signals (c-j), the method comprising applying a reference signal to the apparatus, sampling said reference signal, reading out the samples sequentially and adjusting the timing of one or more of the clock signals in a manner depending on the read-out samples, characterised in that the reference signal is a periodic signal derived from the same source as the respective clock signals and the timing of the one or more clock signals is adjusted to produce a constant output when the samples are read out sequentially.

2. A method as claimed in claim 1 in which the reference signal is a sinewave.

3. A method as claimed in claim 1 or 2 in which the frequency of the reference signal is the same as the sampling frequency of the apparatus.

4. A method as claimed in claim 1 or 2 in which the frequency of the reference signal is half the sampling frequency of the apparatus.

5. A method according to any preceding claim, wherein the step of adjusting the timing of the respective clock signal(s) comprises the step of adjusting the phase of said at least one respective clock signal.

6. A method according to any preceding claim, wherein the step of adjusting the timing of the respective clock signal(s) comprises the step of adjusting the mark/space ratio of said at least one respective clock signal.

7. A sampling apparatus comprising a clock signal generator, a plurality of sampling devices (18) each driven by a respective clock signal from said generator whereby to time multiplex said devices, variable delay means (12,13,14) for selectively delaying the respective clock signals from the generator, means (21,17) for supplying a reference signal to said devices (18) which is sampled, and means (20,15) for adjusting at least one of the variable delay means (12,13,14) in response to the samples when sequentially output; characterised in that the reference signal is a periodic signal derived from the clock signal generator and in that said adjusting means is arranged to adjust the timing of the clock signals to produce a constant output when the samples are read-out sequentially.

8. Apparatus according to claim 7, wherein the adjusting means comprise a digital to analogue converter (15) connected to a varactor diode (14) forming part of the variable delay means.

9. Apparatus according to claim 7 or 8, and comprising means (20,16) for altering the mark-space ratio of the respective clock signals derived from the clock signal generator.

10. Apparatus according to claim 7, 8 or 9 wherein the sampling devices are charge coupled devices.

## Patentansprüche

1. Verfahren zum Kalibrieren einer schnellen Abtastschaltung, bestehend aus mehreren im Zeitmultiplexbetrieb arbeitenden Abtastvorrichtungen (18), die von jeweiligen Taktsignalen (c bis j) gesteuert werden, wobei das Verfahren das Anlegen eines Bezugssignals an die Schaltung, das Abtasten des Bezugssignals, das sequentielle Auslesen der Abtastungen und die Einstellung der Zeitsteuerung auf ein oder mehrere Taktsignale in einer von den ausgelesenen Signalen abhängigen Weise umfaßt,
dadurch gekennzeichnet, daß
das Bezugssignal ein von der gleichen Quelle wie die jeweiligen Taktsignale abgeleitetes periodisches Signal ist, und daß die Zeitsteuerung des einen oder der mehreren Taktsignale eingestellt wird, um ein konstantes Ausgangssignal zu erzeugen, wenn die Abtastungen sequentiell ausgelesen werden.

2. Verfahren nach Anspruch 1,
dadurch gekennzeichnet, daß
das Bezugssignal eine Sinuswelle ist.

3. Verfahren nach Anspruch 1 oder 2,
dadurch gekennzeichnet, daß
die Frequenz des Bezugssignals die gleiche wie die Abtastfrequenz der Schaltung ist.

4. Verfahren nach Anspruch 1 oder 2,
dadurch gekennzeichnet, daß
die Frequenz des Bezugssignals halb so groß wie die Abtastfrequenz der Schaltung ist.

5. Verfahren nach einem der vorhergehenden Ansprüche,
dadurch gekennzeichnet, daß
der Schritt der Einstellung der Zeitsteuerung des jeweiligen Taktsignals bzw. der jeweiligen Taktsignale den Schritt der Einstellung der Phase des wenigstens einen jeweiligen Taktsignals umfaßt.

6. Verfahren nach einem der vorhergehenden Ansprüche,
dadurch gekennzeichnet, daß
der Schritt der Einstellung der Zeitsteuerung des jeweiligen Taktsignals bzw. der jeweiligen Taktsignale den Schritt der Einstellung des Impulstastverhältnisses des wenigstens einen jeweiligen Taktsignals umfaßt.

7. Abtastschaltung,
mit einem Taktsignalgenerator, mit einer Anzahl Abtastvorrichtungen (18), von denen jede mit einem jeweiligen Taktsignal aus dem Taktsignalgenerator gesteuert wird, damit die Abtastvorrichtungen im Zeitmultiplexbetrieb arbeiten, mit veränderbaren Verzögerungselementen (12, 13, 14) für eine selektive Verzögerung der jeweiligen Taktsignale aus dem Taktsignalgenerator, mit einer Einrichtung (21, 17), um den Abtastvorrichtungen (18) ein Bezugssignal zuzuführen, das abgetastet wird, und mit einer Einrichtung (20, 15) zur Einstellung wenigstens eines veränderbaren Verzögerungselementes (12, 13, 14) in Abhängigkeit von den Abtastungen, wenn diese sequentiell ausgelesen werden,
dadurch gekennzeichnet, daß
das Bezugssignal ein periodisches Signal ist, das vom Taktsignalgenerator abgeleitet wird, und daß die Einstelleinrichtung so ausgebildet ist, daß sie eine Zeitsteuerung der Taktsignale einstellt, um ein konstantes Ausgangssignal zu erzeugen, wenn die Abtastungen sequentiell ausgelesen werden.

8. Abtastschaltung nach Anspruch 7,
dadurch gekennzeichnet, daß
die Einstelleinrichtung einen Analog/Digital-Konverter (15) aufweist, der mit einer Varaktor-Diode (14) verknüpft ist, die einen Bestandteil des veränderbaren Verzögerungselementes bildet.

9. Abtastschaltung nach Anspruch 7 oder 8.
dadurch gekennzeichnet, daß
zusätzlich eine Einrichtung vorhanden ist, welche das Impulstastverhältnis des jeweiligen Taktsignales verändert, das aus dem Taktsignalgenerator stammt.

10. Abtastschaltung nach einem der Ansprüche 7, 8 oder 9,
dadurch gekennzeichnet, daß
die Abtastvorrichtungen ladungsgekoppelte Vorrichtungen sind.

## Revendications

1. Procédé d'étalonnage d'un appareil d'échantillonnage à grande vitesse comportant plusieurs dispositifs d'échantillonnage multiplexés dans le temps (18) qui sont commandés par des signaux d'horloge respectifs (c-j), le procédé consistant à appliquer un signal de référence à l'appareil, à échantillonner ledit signal de référence, lire les échantillons séquentiellement et ajuster la position temporelle de l'un ou de plusieurs des signaux d'horloge d'une manière qui dépend des échantillons lus, caractérisé en ce que le signal de référence est un signal périodique obtenu de la même source que les signaux d'horloge respectifs et qu'on ajuste le positionnement temporel du ou des signaux d'horloge considérés de façon à produire un signal de sortie constant lorsque les échantillons sont lus séquentiellement.

2. Procédé selon la revendication 1, dans lequel le signal de référence est une onde sinusoïdale.

3. Procédé selon la revendication 1 ou 2, dans lequel la fréquence du signal de référence est égale à la fréquence d'échantillonnage de l'appareil.

4. Procédé selon la revendication 1 ou 2, dans lequel la fréquence du signal de référence vaut la moitié de la fréquence d'échantillonnage de l'appareil.

5. Procédé selon l'une quelconque des revendications précédentes, où l'opération consistant à ajuster le positionnement temporel du ou des signaux d'horloge respectifs considérés comprend l'opération qui consiste à ajuster la phase du ou des signaux d'horloge respectifs considérés.

6. Procédé selon l'une quelconque des revendications précédentes, où l'opération consistant à ajuster le positionnement temporel du ou des signaux d'horloge respectifs considérés comprend l'opération qui consiste à ajuster le rapport de durée impulsion du ou des signaux d'horloge respectifs considérés.

7. Appareil d'échantillonnage comprenant un générateur de signaux d'horloge, plusieurs dispositifs d'échantillonnage (18) excités chacun par un signal d'horloge respectif fourni par ledit générateur, de façon à multiplexer dans le temps lesdits dispositifs, des moyens retardateurs variables (12, 13, 14) servant à retarder sélectivement les signaux d'horloge respectifs fournis par le générateur, un moyen (21, 17) servant à délivrer un signal de référence auxdits dispositifs (18), lequel est échantillonné, et un moyen (20, 15) servant à ajuster au moins un des moyens retardateurs variables (12, 13, 14) en réponse aux échantillons lorsque ceux-ci sont délivrés en sortie séquentiellement ; caractérisé en ce que le signal de référence est un signal périodique obtenu de la part du générateur de signaux d'horloge et en ce que ledit moyen d'ajustement est conçu pour ajuster le positionnement temporel des signaux d'horloge afin de produire un signal de sortie constant lorsque les échantillons sont lus séquentiellement.

8. Appareil selon la revendication 7, où le moyen d'ajustement comprend un convertisseur numérique-analogique (15) connecté à une diode varactor (14) faisant partie des moyens retardateurs variables.

9. Appareil selon la revendication 7 ou 8, comprenant un moyen (20, 16) servant à changer le rapport de durée d'impulsion des signaux d'horloge respectifs obtenus de la part du générateur de signaux d'horloge.

10. Appareil selon la revendication 7, 8 ou 9, où les dispositifs d'échantillonnage sont des dispositifs à couplage de charge.
